# EUROPÄISCHE PATENTSCHRIFT

(11) **EP 2 100 165 B1**
(45) Veröffentlichungstag und Bekanntmachung des Hinweises auf die Patenterteilung: **25.05.2011**
(21) Anmeldenummer: 07847467.3
(22) Anmeldetag: 28.11.2007
(51) Int. Cl.: G01T 1/00, H03K 3/011

(54) **ANORDNUNG UND VERFAHREN ZUR LADUNGSINTEGRATION**
SYSTEM AND METHOD FOR CHARGE INTEGRATION
SYSTEME ET PROCEDE POUR INTEGRATION DE CHARGE

(30) Priorität: 11.12.2006 DE 102006058291
(43) Veröffentlichungstag der Anmeldung: 16.09.2009
(73) Patentinhaber: Austriamicrosystems AG, 8141 Unterpremstätten (AT)
(72) Erfinder: FITZI, Andreas, 8712 Stäfa (CH)
(74) Vertreter: Epping - Hermann - Fischer
(86) Internationale Anmeldenummer: PCT/EP2007/062949
(87) Internationale Veröffentlichungsnummer: WO 2008/071548

(56) Entgegenhaltungen:
- US-A- 3 619 659
- KALAYJIAN Z K ET AL: "Mismatch in photodiode and phototransistor arrays" CIRCUITS AND SYSTEMS, 2000. PROCEEDINGS. ISCAS 2000 GENEVA. THE 2000 I EEE INTERNATIONAL SYMPOSIUM ON MAY 28-31, 2000, PISCATAWAY, NJ, USA,IEEE, Bd. 4, 28. Mai 2000 (2000-05-28), Seiten 121-124, XP010503552 ISBN: 978-0-7803-5482-1

## Beschreibung

Die Erfindung betrifft eine Anordnung und ein Verfahren zur Ladungsintegration sowie eine Verwendung der Anordnung.

Viele Sensoren in technischen Anwendungen erzeugen Ladungen, welche als Sensorsignal abgegeben werden. Dabei können beispielsweise Ströme auftreten, die relativ gering sind. Deswegen werden üblicherweise die Ladungen integriert und in Spannungen umgesetzt. Ein Beispiel für derartige Sensoren sind Photodioden in einem Sensorfeld eines digitalen Röntgengeräts.

Um eine ausreichende Bildqualität für digitale Röntgenbilder zu erreichen, ist es wünschenswert, dass eine Schaltung, die zur Ladungsintegration verwendet wird, ein lineares Integrationsverhalten und geringes Rauschen aufweist. Ferner sollte eine derartige Schaltung für gewünschte Bildraten, englisch: frame rates, geeignet sein und wenig Strom verbrauchen, um ein Aufheizen und eine damit verbundene Beeinflussung von temperaturabhängigen Komponenten zu vermeiden.

Für eine Integration werden vielfach kapazitive Elemente eingesetzt, die kleine Kapazitätswerte aufweisen, um höhere Spannungen zu erreichen. Zusätzlich werden Schalter verwendet, um den Integrationsvorgang zu steuern. Diese weisen oft parasitäre Kapazitäten auf, die beispielsweise aus Sperrschichtkapazitäten beim Einsatz von Halbleiterschaltern resultieren, welche spannungsabhängig sind. Die parasitären Kapazitäten können hierbei die Genauigkeit bei der Integration beeinflussen. Zusätzlich kann der ladungsbereitstellende Sensor parasitäre Kapazitäten aufweisen, beispielsweise ebenfalls aufgrund eingesetzter Schalter oder in Form von Leitungskapazitäten, die in Abhängigkeit von Rauschen in der Schaltung das Integrationsergebnis verfälschen.

Um die Genauigkeit oder den Arbeitsbereich einer Schaltung zur Integration zu verbessern, kann zusätzlich zu der Ladung, die von einem Sensor bereitgestellt wird, eine weitere Ladung mit in die Integration einbezogen werden, wobei sich dieser zusätzliche Anteil aus dem späteren Integrationsergebnis herausrechnen lässt. Beim Erzeugen der weiteren Ladung können jedoch temperaturabhängige Schwankungen auftreten, die als Fehler in das Integrationsergebnis eingehen.

Aus dem Dokument US 3,619,659 ist eine Anordnung mit einem Integrationsverstärker bekannt, mit der trapezförmige Signale mit vorbestimmten Anstiegs- und Abfallzeiten erzeugt werden können. Die Signalerzeugung soll dabei möglichst temperaturunabhängig erfolgen.

Es ist Aufgabe der Erfindung, eine Anordnung und ein Verfahren zur Ladungsintegration anzugeben, mit denen eine Ladungsintegration mit verbesserter Genauigkeit und verringerter Temperaturabhängigkeit durchgeführt werden kann. Es ist auch Aufgabe der Erfindung, eine Verwendung für die Anordnung anzugeben.

Diese Aufgaben werden mit den Gegenständen der unabhängigen Patentansprüche gelöst. Ausgestaltungsformen und Weiterbildungen der Erfindung sind Gegenstand der Unteransprüche.

In einem Ausführungsbeispiel der Erfindung umfasst eine Anordnung zur Ladungsintegration einen Eingang zur Zuführung eines ladungsabhängigen Signals sowie einen Integrator, der zur Integration eines eingangsseitig anliegenden Signals ausgeführt ist. Ferner ist eine Kopplungsschaltung mit wenigstens zwei einnehmbaren Betriebszuständen vorgesehen, die zur Kopplung des Eingangs mit dem Integrator dient. Dabei weist die Kopplungsschaltung ein temperaturabhängiges Kopplungsverhalten auf. Die Anordnung zur Ladungsintegration umfasst ferner eine getaktet betreibbare Korrekturschaltung, die zur Übertragung einer Ladungsmenge mit dem Eingang gekoppelt ist und ein Temperaturverhalten aufweist, das vom Kopplungsverhalten der Kopplungsschaltung abgeleitet ist.

Der Anordnung wird beispielsweise von einem ladungserzeugenden Sensor wie einer Photodiode ein ladungsabhängiges Signal zugeführt. Das ladungsabhängige Signal wird von der Kopplungsschaltung an den Integrator zur Erzeugung des Ausgangssignals weitergeleitet. Dabei kann sich beispielsweise in Abhängigkeit der Betriebstemperatur der Anordnung das Übertragungsverhalten der Kopplungsschaltung ändern, so dass eine höhere oder geringere Ladungsmenge zur Integration weitergeleitet wird, ausgehend zum Beispiel von einer Referenztemperatur.

In der Korrekturschaltung kann eine Ladungsmenge generiert werden, welche zusätzlich zu dem ladungsabhängigen Signal über die Kopplungsschaltung zur Integration weitergeleitet wird. Dabei kann die Ladungsmenge, ausgehend von einem vorgegebenen Ladungswert, temperaturabhängig derart angepasst werden, dass Abweichungen, die aufgrund der Temperaturschwankungen in der Kopplungsschaltung auftreten, ausgeglichen werden. Somit kann erreicht werden, dass unabhängig von der Temperatur eine bestimmte Ladungsmenge im Integrator integriert wird, welche in einer nachgeschalteten Verarbeitungseinheit mit geringem Aufwand aus einem Integrationsergebnis herausgerechnet werden kann.

Beispielsweise ist die Korrekturschaltung derart dimensioniert, dass diese ein Temperaturverhalten aufweist, welches zur Kompensation des temperaturabhängigen Kopplungsverhaltens der Kopplungsschaltung dient. Anders ausgedrückt ist durch diese Dimensionierung das Temperaturverhalten der Korrekturschaltung aus dem gegebenen Temperaturverhalten der Kopplungsschaltung abgeleitet.

Das Erzeugen der an die Temperatur angepassten Ladungsmenge in der Korrekturschaltung kann in einer Ausführungsform der Erfindung in einem geschalteten oder getakteten Betrieb erfolgen. Die Korrekturschaltung weist demnach ein taktabhängiges Verhalten auf, das zum Beispiel durch getaktet betriebene Schalter gegeben ist. Beispielsweise kann zunächst die Korrekturschaltung derart betrieben werden, dass taktabhängig eine feste Ladungsmenge erzeugt beziehungsweise gespeichert wird. Diese Ladungsmenge kann in einem weiteren Zeitabschnitt temperaturabhängig angepasst werden, um in einem späteren Zeitabschnitt mit dem ladungsabhängigen Signal am Eingang zusammengeführt zu werden.

In einer weiteren Ausführungsform umfasst die Kopplungsschaltung einen ersten und einen zweiten Transistor. Der erste Transistor ist dabei in Abhängigkeit des ladungsabhängigen Signals steuerbar. Der zweite Transistor ist dazu ausgebildet, das ladungsabhängige Signal in Abhängigkeit einer Steuerung weiterzuleiten, die durch den ersten Transistor erfolgt. Durch das Koppeln des Integrators mit dem Eingang über die Kopplungsschaltung kann der Einfluss von parasitären Kapazitäten, welche beispielsweise in einem am Eingang angeschlossenen Sensor auftreten, verringert werden. Dies führt zu verringerten Linearitätsabweichungen und einer verbesserten Genauigkeit bei der Integration.

In einem weiteren Ausführungsbeispiel einer Anordnung zur Ladungsintegration umfasst die Korrekturschaltung einen mit dem

Eingang schaltbar gekoppelten Ladungsspeicher sowie einen dritten und einen vierten Transistor. Der Ladungsspeicher kann einen von einer vorbestimmten Ladespannung abhängigen Ladezustand annehmen, etwa durch eine getaktet schaltbare Kopplung mit einem Ladepotenzialanschluss. Der dritte Transistor wird in Abhängigkeit des Ladezustands des Ladungsspeichers gesteuert. Der vierte Transistor ist dazu ausgebildet, in Abhängigkeit einer Steuerung, die durch den dritten Transistor erfolgt, den Ladezustand des Ladungsspeichers zu beeinflussen. Der erste Transistor in der Kopplungsschaltung und der dritte Transistor in der Korrekturschaltung können ein sich einander entsprechendes Temperaturverhalten aufweisen. Beispielsweise haben der erste und der dritte Transistor bei gleicher Temperatur ein gleiches Steuerverhalten, zum Beispiel einen vergleichbaren gesteuerten Strom bei gleicher Steuerspannung.

Die Transistoren der Kopplungsschaltung und der Korrekturschaltung sind beispielsweise als Feldeffekttransistoren ausgeführt, etwa als Sperrschicht-Feldeffekttransistoren, JFET, oder als Feldeffekttransistoren mit isoliertem Gate, IGFET. In verschiedenen Ausführungsformen können die Transistoren auch durch Metalloxyd-Halbleiter-Feldeffekttransistoren, MOSFET gebildet sein. Bei einer Ausbildung als Feldeffekttransistoren weisen der erste und der dritte Transistor beispielsweise bei gleicher Temperatur eine gleiche Schwellenspannung, englisch: threshold voltage auf.

Die Transistoren der Kopplungsschaltung und die Transistoren der Korrekturschaltung können jeweils in ähnlicher Weise verschaltet sein. Somit können temperaturabhängige Effekte beim Schalten beziehungsweise Steuern der Transistoren in gleichem Maße beim Weiterleiten des Signals in der Kopplungsschaltung wie beim Beeinflussen des Ladezustands des Ladungsspeichers in der Korrekturschaltung auftreten und sich gegenseitig ausgleichen.

Die Korrekturschaltung und die Kopplungsschaltung umfassen in einer Ausführungsform jeweils eine Stromquelle, die ein einander entsprechendes Temperaturverhalten aufweisen, also beispielsweise eine sich entsprechende Stromabhängigkeit von der Temperatur. Die Stromquellen können beispielsweise zur Erzeugung von Steuersignalen für die Steuerung des zweiten beziehungsweise vierten Transistors eingesetzt werden.

In einem weiteren Ausführungsbeispiel weist der Integrator einen Differenzverstärker auf, der über einen kapazitiven Ladungsspeicher rückgekoppelt ist. Dabei kann der weitere Ladungsspeicher in Abhängigkeit eines weiteren Steuersignals entladbar sein. Der kapazitive Ladungsspeicher ist beispielsweise als Kondensator ausgeführt.

Dementsprechend kann eine Ladung beziehungsweise ein ladungsabhängiges Signal, welche am Eingang und von der Korrekturschaltung empfangen werden, über den kapazitiven Ladungsspeicher des Integrators zu einer Spannung aufintegriert werden, welche von der erzeugten Ladungsmenge abhängt. Das Entladen kann beispielsweise über einen Schalter erfolgen, der parallel zu dem kapazitiven Ladungsspeicher geschaltet ist.

In einer weiteren Ausführungsform der Erfindung kann das ladungsabhängige Signal dem Integrator über eine Schalteinrichtung zugeführt werden, die in Abhängigkeit eines weiteren Steuersignals schaltbar ist. Dadurch kann die Ladungserzeugungsschaltung beziehungsweise die Kopplungsschaltung mit dem Integrator verbunden oder vom Integrator getrennt werden, um den Integrationsvorgang gezielt steuern zu können.

In einem Ausführungsbeispiel eines erfindungsgemäßen Verfahrens zur Ladungsintegration wird eine vorbestimmte Ladungsmenge gespeichert, zum Beispiel auf einem kapazitiven Ladungsspeicher. In Abhängigkeit der gespeicherten Ladungsmenge wird ein erstes Steuersignal erzeugt. Die gespeicherte Ladungsmenge wird in Abhängigkeit des ersten Steuersignals angepasst. Die angepasste Ladungsmenge dient als Grundlage für die Erzeugung eines ersten ladungsabhängigen Signals. Das erste ladungsabhängige Signal wird mit einem zugeführten zweiten ladungsabhängigen Signal zusammengeführt, in dessen Abhängigkeit ein zweites Steuersignal erzeugt wird. Das zusammengeführte Signal wird in Abhängigkeit des zweiten Steuersignals weitergeleitet und zu einem Ausgangssignal integriert.

Das Erzeugen des ersten und zweiten Steuersignals kann dabei temperaturabhängig erfolgen, so dass sowohl das Weiterleiten des zusammengeführten Signals als auch das Anpassen der gespeicherten Ladungsmenge in gleichem Maße von der Temperatur abhängig sind. Somit können Temperatureinflüsse beim Weiterleiten durch die Beeinflussung der gespeicherten Ladungsmenge kompensiert werden. Dies führt auch zu einem genaueren und temperaturunabhängigeren Integrationsergebnis.

Im Folgenden wird die Erfindung an mehreren Ausführungsbeispielen anhand der Figuren näher erläutert. Funktions- beziehungsweise wirkungsgleiche Elemente tragen dabei gleiche Bezugszeichen.

Es zeigen:
- Figur 1: ein erstes Ausführungsbeispiel einer Anordnung zur Ladungsintegration,
- Figur 2: ein zweites Ausführungsbeispiel einer Anordnung zur Ladungsintegration,
- Figur 3: ein Signal-Zeit-Diagramm für Steuersignale in einem Ausführungsbeispiel einer Korrektureinrichtung,
- Figur 4: ein Ausführungsbeispiel eines Integrators und
- Figur 5: ein Ausführungsbeispiel einer Transistor- Stromquelle.

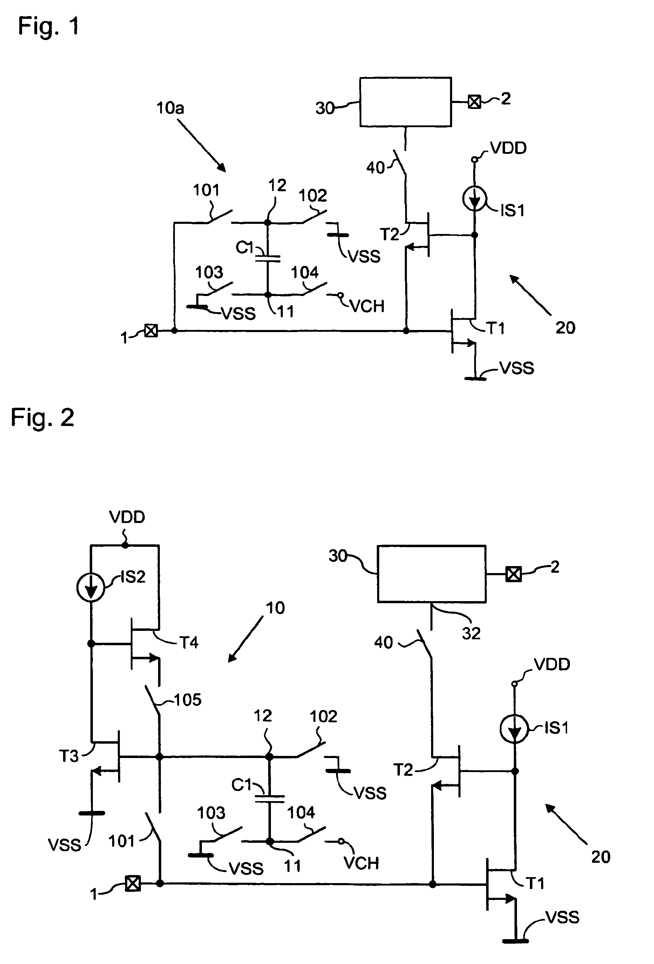

Figur 1 zeigt ein Ausführungsbeispiel einer Anordnung zur Ladungsintegration, die eine Korrekturschaltung 10A, eine Kopplungsschaltung 20 und einen Integrator 30 umfasst. Die Korrekturschaltung 10A und die Kopplungsschaltung 20 sind dabei an einen Eingang 1 angeschlossen, über den ein ladungsabhängiges Signal zugeführt werden kann. Der Integrator 30 ist eingangsseitig über eine Schalteinrichtung 40 mit der Kopplungsschaltung 20 und ausgangsseitig mit einem Ausgang 2 gekoppelt, über den ein Integrationsergebnis abgegriffen werden kann. Die Kopplungsschaltung 20 umfasst einen ersten und einen zweiten Transistor T1, T2, die in diesem Ausführungsbeispiel als n-Kanal-Feldeffekttransistoren ausgeführt sind. Ein Steuer- oder Gate-Anschluss des ersten Transistors T1 und ein Source-Anschluss des zweiten Transistors T2 sind dabei mit dem Eingang 1 gekoppelt. Ferner sind ein Steuer- oder Gate-Anschluss des zweiten Transistors T2 und ein Drain-Anschluss des ersten Transistors T1 gemeinsam über eine Stromquelle IS1 mit einem Versorgungspotenzialanschluss VDD gekoppelt. Ein Source-Anschluss des ersten Transistors T1 ist an einen Bezugspotenzialanschluss VSS angeschlossen. Ein Drain-Anschluss des zweiten Transistors T2 bildet den Ausgang der Kopplungsschaltung 20, der über die Schalteinrichtung 40 mit dem Integrator 30 gekoppelt ist.

Die Korrekturschaltung 10A umfasst einen kapazitiven Ladungsspeicher C1 und Schalter 101, 102, 103, 104, durch die der Ladungsspeicher C1 mit Anschlüssen unterschiedlichen Potenzials verbunden werden kann. Der Ladungsspeicher C1 ist beispielsweise als Kondensator ausgeführt. Man kann auch sagen, dass die Korrekturschaltung 10A als Schaltung mit geschaltetem Kondensator, englisch: switched capacitor circuit ausgeführt ist. Beispielsweise kann ein erster Anschluss 11 des Ladungsspeicher C1 über den Schalter 104 mit einem Ladepotenzialanschluss VCH gekoppelt werden. Alternativ kann der Anschluss 11 über den Schalter 103 mit dem Bezugspotenzialanschluss VSS gekoppelt werden. Ein zweiter Anschluss 12 kann über den Schalter 102 mit dem Bezugspotenzialanschluss VSS oder über den Schalter 101 mit dem Eingang 1 gekoppelt werden.

Durch die n-Kanal-Feldeffekttransistoren T1, T2 ist die Anordnung zur Ladungsintegration grundsätzlich zur Integration von negativen Ladungen eingerichtet, das heißt zur Integration eines Stroms vom Integrator 30 hin zu einem am Eingang 1 angeschlossenen ladungserzeugenden Sensor. Wenn im Betrieb der Anordnung ein Strom zum Eingang 1 fließt, sinkt das Potenzial am Gate-Anschluss des Transistors T1 von einem üblicherweise höheren Wert, bei dem der Transistor T1 in einem leitenden Zustand ist, auf einen niedrigeren Wert, bei dem der Transistor T1 in einen sperrenden Zustand gelangt. Dadurch steigt das Potenzial am Drain-Anschluss des Transistors T1 beziehungsweise am Gate-Anschluss des Transistors T2, so dass dieser in einen leitenden Zustand gesteuert wird.

Bei in Abhängigkeit eines Steuersignals geschlossenem Schalter 40 kann somit ein Strom vom Integrator 30 über den Schalter 40 und den Transistor T2 hin zum Eingang 1 fließen, der im Integrator 30 zu einem Integrationsergebnis verarbeitet wird. Durch den Stromfluss kann sich am Gate-Anschluss des ersten Transistors T1 eine Spannung einstellen, die ungefähr um eine Schwellenspannung V_{THT1} höher ist als eine Spannung am Bezugspotenzialanschluss VSS. Diese Spannung kann auch als Gleichgewichtsspannung VEQ1 der Kopplungsschaltung 20 betrachtet werden. Anders ausgedrückt ergibt sich am Gate-Anschluss des Transistors T1 eine Spannung, bei der dieser zu leiten beginnt, aber ein Stromfluss über den Transistor T2 dennoch möglich ist.

Um mit der Anordnung zur Ladungsintegration auch positive Ladungen integrieren zu können, kann über die Korrekturschaltung 10A eine zusätzliche negative Ladung auf den Eingang 1 aufgebracht werden. Dazu wird in einem ersten Zeitabschnitt der Ladungsspeicher C1 auf eine Spannung aufgeladen, die den Spannungsunterschied zwischen einer Ladespannung am Ladepotenzialanschluss VCH und einem Bezugspotenzial am Bezugspotenzialanschluss VSS entspricht, indem die Schalter 102 und 104 in einen geschlossenen Zustand gebracht werden. In einem zweiten Zeitabschnitt werden die Schalter 102, 104 geöffnet und die Schalter 101, 103 geschlossen. Somit kann bei einem Integrationsvorgang im zweiten Zeitabschnitt der Eingang 1 mit der gespeicherten Spannung beziehungsweise der entsprechend gespeicherten Ladungsmenge des Ladungsspeichers C1 beaufschlagt werden. Dabei wird der Ladungsspeicher C1 so umgeladen, dass sich am Anschluss 12 die vorher angesprochene Gleichgewichtsspannung VEQ1 der Kopplungsschaltung 20 einstellt.

Dementsprechend wird eine Ladung auf den Eingang 1 beziehungsweise den Integrator 30 übertragen, welche dem Produkt des Kapazitätswerts des Ladungsspeichers C1 mit dem Spannungsunterschied zwischen der Gleichgewichtsspannung VEQ1 und der Ladespannung entspricht. Diese Ladungsmenge, die zusätzlich zu einer am Eingang 1 von einem Sensor bereitgestellten Ladungsmenge vom Integrator 30 integriert wird, kann bei einer späteren Verarbeitung des Integrationsergebnisses abgezogen werden. Durch die zusätzliche negative Ladung des Ladungsspeichers C1 können somit auch positive Ladungen am Eingang 1 der Anordnung bei einem Integrationsvorgang berücksichtigt werden.

Die Ladespannung am Ladepotenzialanschluss VCH kann einen beliebigen konstanten und bekannten Wert annehmen, der üblicherweise zwischen einem Spannungswert am Bezugspotenzialanschluss VSS und einer Spannung am Versorgungspotenzialanschluss VDD liegt.

Wie zuvor angesprochen, hängt die vom Ladungsspeicher übertragene Ladungsmenge von der Gleichgewichtsspannung der Kopplungsschaltung 20 ab, die wiederum eine Funktion der Schwellenspannung V_{THT1} des ersten Transistors T1 ist. Da die Schwellenspannung V_{THT1} aber eine temperaturabhängige Größe ist, kann es bei Temperaturschwankungen, beispielsweise durch das Aufheizen von Bauteilen, zu einer temperaturabhängigen Beeinflussung der vom Ladungsspeicher C1 abgegebenen Ladungsmenge kommen. Derartige Abweichungen können jedoch nicht ohne weiteres bei einer Nachbearbeitung des Integrationsergebnisses berücksichtigt werden, was zu einer Beeinträchtigung der Genauigkeit führen kann.

Figur 2 zeigt ein weiteres Ausführungsbeispiel einer Anordnung zur Ladungsintegration, in der eine alternative Korrekturschaltung 10 vorgesehen ist. Ähnlich wie die Korrekturschaltung 10A aus Figur 1 umfasst die Korrekturschaltung 10 einen kapazitiven Ladungsspeicher C1 mit Schaltern 101, 102, 103, 104. Die Korrekturschaltung 10 umfasst in diesem Ausführungsbeispiel zusätzlich einen dritten und einen vierten Transistor T3, T4, die wie die Transistoren T1, T2 als n-Kanal-Feldeffekttransistoren ausgeführt sind. Ferner ist eine zweite Stromquelle IS2 vorgesehen.

Die Transistoren T3 und T4 sind ähnlich wie die Transistoren T1 und T2 verschaltet. Der Gate-Anschluss oder Steueranschluss des dritten Transistors T3 ist über einen Schalter 105 mit dem Source-Anschluss des vierten Transistors T4 gekoppelt. Der Steueranschluss oder Gate-Anschluss des vierten Transistors T4 ist gemeinsam mit dem Drain-Anschluss des dritten Transistors T3 über die Stromquelle IS2 mit dem Versorgungspotenzialanschluss VDD gekoppelt ist. Ferner ist der Drain-Anschluss des vierten Transistors T4 an den Versorgungspotenzialanschluss VDD angeschlossen. Der Transistor T3 weist vorzugsweise das gleiche Temperaturverhalten wie der Transistor T1 auf. Insbesondere entsprechen sich vorzugsweise Einsatz- beziehungsweise Schwellenspannungen V_{THT1}, V_{THT3} der Transistoren T1, T3. Ebenso weisen die Transistoren T2, T4 in verschiedenen Ausführungsformen jeweils gleiches Temperaturverhalten auf. Da auch die Stromquellen IS1, IS2 ein temperaturabhängiges Verhalten aufweisen können, ist es wünschenswert, dass sich auch deren jeweilige Temperaturverhalten einander entsprechen.

Im Betrieb der Anordnung kann sich bei der Integration am Gate-Anschluss des Transistors T1 wiederum eine Gleichgewichtsspannung VEQ1 einstellen, die dem Spannungsunterschied zwischen der Schwellenspannung V_{THT1} und der Spannung am Bezugspotenzialanschluss VSS entspricht. In der Korrekturschaltung 10 kann der Ladungsspeicher C1 über die Schalter 102 bis 105 mit einer Ladung beaufschlagt werden, welche über den Schalter 101 an den Eingang 1 zuführbar ist.

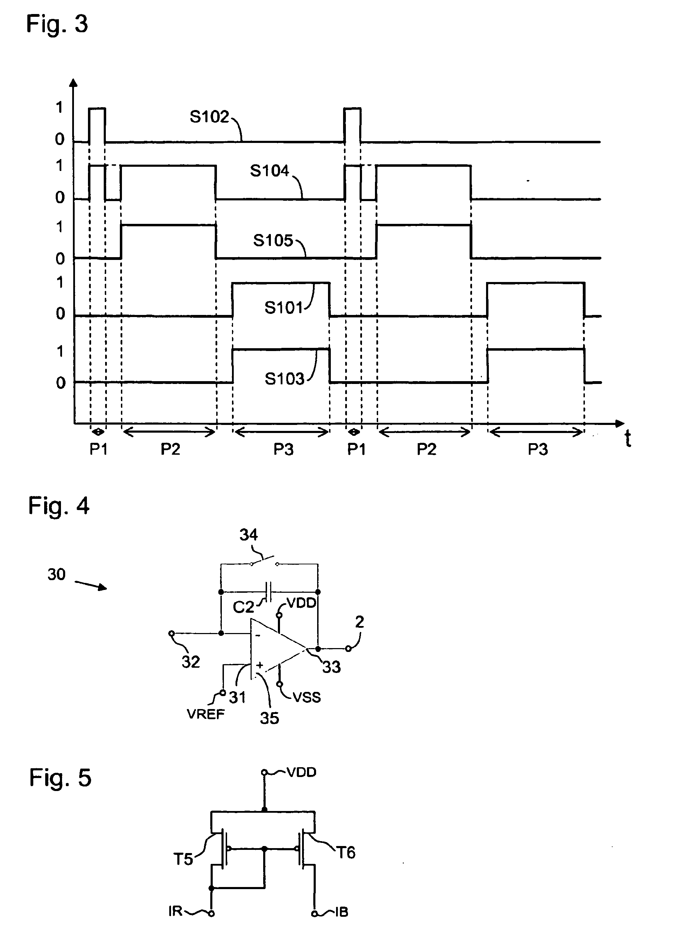

Figur 3 zeigt ein Signal-Zeit-Diagramm für Steuersignale für die Schalter 101 bis 105, durch die die Korrekturschaltung 10 getaktet betrieben wird. Bei den Steuersignalen S101 bis S105 stellt jeweils ein Pegel von Null einen offenen Schalter und ein Pegel von Eins einen geschlossenen Schalter dar. In einem ersten Zeitabschnitt P1, der auch als Resetphase bezeichnet werden kann, werden die Schalter 102, 104 in Abhängigkeit der Steuersignale S102, S104 geschlossen. Dadurch wird der Ladungsspeicher C1 mit einer Spannung am Anschluss 11 gegenüber dem Anschluss 12 aufgeladen, die dem Spannungsunterschied zwischen der Ladespannung und dem Bezugspotenzial entspricht.

In einem zweiten Zeitabschnitt P2 sind die Schalter 104, 105 in Abhängigkeit der Steuersignale S104, S105 geschlossen, während die übrigen Schalter 101, 102, 103 geöffnet sind. Der zweite Zeitabschnitt P2, der auch als Ladephase bezeichnet werden kann, kann unmittelbar auf den ersten Zeitabschnitt P1 folgen. Jedoch kann auch zwischen dem ersten und dem zweiten Zeitabschnitt P1, P2 ein zeitlicher Abstand gewählt werden, damit Schaltvorgänge der jeweiligen Schalter, die beispielsweise als Transistorschalter ausgeführt sind, sicher abgeschlossen sind. Der Schalter 104 kann dabei zwischen der ersten und der zweiten Phase P1, P2 geschlossen bleiben oder kurzzeitig geöffnet werden.

Durch die Spannungsverhältnisse im Ladungsspeicher C1 beziehungsweise durch dessen Ladezustand liegt unmittelbar nach Schließen des Schalters 105 ein Potenzial am Gate-Anschluss des Transistors T3 an, bei dem der Transistor T3 in einem gesperrten Zustand ist. Dementsprechend herrscht am Drain-Anschluss des Transistors T3 beziehungsweise Gate-Anschluss des Transistors T4 ein Potenzial, welches den Transistor T4 in einen leitenden Zustand versetzt. Durch die solchermaßen erfolgende Kopplung mit dem Versorgungspotenzialanschluss VDD verändert sich das Potenzial am Knoten 12 derart, dass sich ähnlich wie in der Kopplungsschaltung 20 eine Gleichgewichtsspannung VEQ2 einstellt, die aus dem Spannungsunterschied zwischen der Schwellenspannung V_{THT3} des Transistors T3 und dem Bezugspotenzial resultiert.

Somit ist der dritte Transistor T3 in Abhängigkeit des Ladezustands des Ladungsspeichers in der Form gesteuert, dass dieser ein Steuersignal für den Transistor T4 erzeugt. In Abhängigkeit dieser Steuerung durch den dritten Transistor T3 wird der Ladezustand des Ladungsspeichers C1 derart beeinflusst, dass dieser eine Ladespannung annimmt, die dem Spannungsunterschied zwischen der Ladespannung und der Gleichgewichtsspannung VEQ2 der Korrekturschaltung 10 entspricht.

In einem dritten Zeitabschnitt P3 sind die Schalter 102, 104, 105 in einem geöffneten Zustand und die Schalter 101, 103 in Abhängigkeit der Steuersignale S101, S103 in einem geschlossenen Zustand. Der dritte Zeitabschnitt P3 kann auch als Injektions- oder Übertragungsphase bezeichnet werden. In dem dritten Zeitabschnitt P3 wird die auf dem Ladungsspeicher C1 gespeicherte Ladungsmenge an den Eingang 1 beziehungsweise zur Integration an den Integrator 30 abgegeben. Dabei wird, ähnlich wie im Ausführungsbeispiel in Figur 1 beschrieben, der Anschluss 12 des Ladungsspeichers C1 auf die Gleichgewichtsspannung der Kopplungsschaltung 20 umgeladen. Anders ausgedrückt wird durch die Korrekturschaltung 10 ein weiteres ladungsabhängiges Signal erzeugt.

Dadurch kann eine Ladung an den Integrator 30 übertragen werden, die dem Produkt des Kapazitätswerts des Ladungsspeichers C1 mit dem Spannungsunterschied aus der Spannung über den Ladungsspeicher C1 und der Gleichgewichtsspannung VEQ1 der Kopplungsschaltung 20 entspricht. Da die Spannung über den Ladungsspeicher C1 von der Gleichgewichtsspannung VEQ2 der Korrekturschaltung 10 abhängt, heben sich bei der Berechnung der übertragenen Ladungsmenge die Gleichgewichtsspannung VEQ2 der Korrekturschaltung 10 und die Gleichgewichtsspannung VEQ1 der Kopplungsschaltung 20 gegenseitig auf, wenn diese aufgrund gleichen Temperaturverhaltens gleich groß sind. Damit ergibt sich für die übertragene Ladungsmenge ein temperaturunabhängiger Wert, entsprechend dem Produkt des Kapazitätswerts des Ladungsspeichers C1 mit der Ladespannung am Ladepotenzialanschluss VCH, wobei der Wert in diesem Ausführungsbeispiel eine negative Ladungsmenge darstellt.

Die Transistoren T3 und T4 können skalierte Versionen der Transistoren T1 und T2 sein. Dadurch können die Transistoren T3 und T4 in der Korrekturschaltung mit einem geringen Strom betrieben werden, der kleiner sein kann als ein entsprechender Strom in der Kopplungsschaltung 20. Demgemäß kann auch die zweite Stromquelle IS2 eine skalierte Version der ersten Stromquelle IS1 sein. Jedoch sollte das Temperaturverhalten der jeweiligen Elemente in der Korrekturschaltung 10 dem der entsprechenden Elemente in der Kopplungsschaltung 20 entsprechen. Anders ausgedrückt kann die Korrekturschaltung ein Temperaturverhalten aufweisen, das vom temperaturabhängigen Kopplungsverhalten der Kopplungsschaltung 20 abgeleitet ist.

Durch einen geringeren Strombedarf der Korrekturschaltung 10 ist die Anordnung zur Integration auch für Anwendungen geeignet, bei denen auf einen geringen Stromverbrauch bei gleichzeitig niedrigem Rauschen Wert gelegt wird.

Einschwingvorgänge in der Korrekturschaltung 10 hängen vom Kapazitätswert des Ladungsspeichers C1 und von den Widerstandswerten der jeweiligen Schalter in geschlossenem Zustand ab. Um die Einschwingzeiten möglichst kurz zu halten, können beispielsweise Schalter gewählt werden, die einen geringen Widerstandswert im leitenden Zustand aufweisen. Die Länge der Zeitabschnitte P1, P2, P3 ist dabei üblicherweise so gewählt, dass Einschwingvorgänge vollständig abgeschlossen sind, das heißt Umladevorgänge vollständig erfolgt sind. Somit ist die übertragene Ladungsmenge unabhängig von der Temperatur. Zudem kann die Anordnung zur Ladungsintegration auch für Hochgeschwindigkeitsanwendungen eingesetzt werden.

Da die Ladespannung einer Spannung zwischen einem Versorgungspotenzial und dem Bezugspotenzial entspricht, ist es nicht notwendig, Spannungen von außen an die Anordnung zuzuführen, die außerhalb dieses Spannungsbereichs liegen. Dementsprechend können Bauelemente in der Anordnung in günstiger CMOS-Technologie aufgebaut werden.

In einem weiteren Ausführungsbeispiel wird eine vorbestimmte Ladungsmenge gespeichert, beispielsweise auf dem Ladungsspeicher C1 in Abhängigkeit der Ladespannung am Ladepotenzialanschluss VCH. Über den Transistor T3 wird in Abhängigkeit der gespeicherten Ladungsmenge ein erstes Steuersignal erzeugt, das zur Ansteuerung des Transistors T4 dient. Somit wird die gespeicherte Ladungsmenge in Abhängigkeit des ersten Steuersignals über den Transistor T4 angepasst. Der Ladungsspeicher wird an den Eingang 1 gekoppelt und dadurch ein erstes ladungsabhängiges Signal als Funktion der angepassten Ladungsmenge erzeugt. Über den Eingang 1 wird ein zweites ladungsabhängiges Signal, beispielsweise von einem ladungserzeugenden Sensor, zugeführt und mit dem ersten ladungsabhängigen Signal zusammengeführt. Über den Transistor T1 wird in Abhängigkeit des zusammengeführten Signals ein zweites Steuersignal erzeugt, durch das der zweite Transistor T2 gesteuert wird. Beispielsweise leitet der Transistor T2 das zusammengeführte Signal in Abhängigkeit des Steuersignals weiter, so dass es im Integrator 30 zu einem Ausgangssignal integriert werden kann.

Da die Transistoren T1, T3 ein temperaturabhängiges Verhalten aufweisen können, werden das erste und das zweite Steuersignal beispielsweise temperaturabhängig erzeugt.

Mit Verweis auf Figur 3 können nach dem Zeitabschnitt P3 ein weiterer erster Zeitabschnitt P1, ein weiterer zweiter Zeitabschnitt P2 und ein weiterer dritter Zeitabschnitt P3 folgen. Anders ausgedrückt kann für jeden Integrationsvorgang eine Resetphase, eine Ladephase und eine Injektionsphase vorgesehen werden, um jeweils die vorbestimmte, temperaturunabhängige Ladungsmenge für den Integrationsvorgang bereit zu stellen.

Die Integration kann beispielsweise im Integrator 30 über einen schaltbaren kapazitiven Ladungsspeicher erfolgen. Alternativ kann eine Integration über einen Differenzverstärker oder Operationsverstärker erfolgen, der kapazitiv rückgekoppelt ist.

Figur 4 zeigt ein Ausführungsbeispiel eines Integrators 30, der beispielsweise in den Ausführungsbeispielen gemäß Figur 1 oder Figur 2 eingesetzt werden kann. Der Integrator 30 umfasst einen Differenzverstärker 35 mit einem ersten, nicht invertierenden Eingang 31, der mit einem Referenzspannungsanschluss VREF gekoppelt ist. Ein zweiter, invertierender Eingang 32 des Differenzverstärkers 35 bildet einen Eingang des Integrators 30. Ein Ausgang 33 des Differenzverstärkers 35 ist über einen zweiten kapazitiven Ladungsspeicher C2 und einen dazu parallel geschalteten Schalter 34 mit dem zweiten Eingang 32 gekoppelt. Ferner ist der Ausgang 33 des Differenzverstärkers 35 mit dem Ausgang 2 zur Abgabe des Integrationsergebnisses gekoppelt.

Eine Versorgung des Differenzverstärkers 35 erfolgt beispielsweise über den Versorgungspotenzialanschluss VDD und den Bezugspotenzialanschluss VSS. Der Schalter 34 kann zum Rücksetzen des Ladungsspeichers C2 geschlossen werden, um einen definierten Ausgangszustand für eine Integration zu erreichen. Beim eigentlichen Integrationsvorgang ist der Schalter 34 geöffnet und, mit Verweis auf Figur 2, die Schalteinrichtung 40 geschlossen, um ein Aufladen des Ladungsspeichers C2 zu ermöglichen. Beim Entladen des Ladungsspeichers C2 über den Schalter 34 ist die Schalteinrichtung 40 üblicherweise geöffnet, um den Entladevorgang unabhängig vom Rest der Schaltung durchführen zu können.

Der kapazitive Ladungsspeicher C2 ist beispielsweise als Kondensator ausgeführt. Eine Spannung am Referenzpotenzialanschluss VREF kann zum Beispiel durch ein Massepotenzial gegeben sein.

Figur 5 zeigt ein Ausführungsbeispiel einer Transistorstromquelle, welche in dieser Form sowohl für die erste als auch die zweite Stromquelle IS1, IS2 verwendet werden kann. Die Stromquelle umfasst ein Transistorpaar T5, T6, die als Stromspiegel verschaltet sind. Die Transistoren T5 und T6 sind in diesem Ausführungsbeispiel als p-Kanal-Feldeffekttransistoren ausgeführt. Über den Referenzanschluss IR kann ein Referenzstrom zugeführt werden, welcher abhängig von einem Größenverhältnis der Transistoren T5, T6 zu einem entsprechenden Ausgangsstrom am Stromausgang IB führt.

Für die in den Ausführungsbeispielen dargestellten Transistoren können sowohl Feldeffekttransistoren mit isoliertem Gate als auch Sperrschicht-Feldeffekttransistoren eingesetzt werden. Es ist jedoch auch möglich, Bipolar-Transistoren einzusetzen. Ferner können in weiteren Ausführungsformen der Anordnung zur Ladungsintegration die n-Kanal-Feldeffekttransistoren durch komplementäre p-Kanal-Feldeffekttransistoren ersetzt werden. Beispielsweise ist eine Anordnung zur Ladungsintegration mit p-Kanal-Feldeffekttransistoren grundsätzlich zur Integration von positiven Ladungen eingerichtet. Entsprechend vertauschte Stromrichtungen sind dabei zu berücksichtigen.

Eine Anordnung zur Ladungsintegration gemäß einem der vorgeschlagenen Ausführungsbeispiele kann beispielsweise in einem digitalen Röntgengerät verwendet werden. Dabei werden die Ladungsträger beziehungsweise das ladungsabhängige Signal am Eingang 1 zum Beispiel von Photodioden erzeugt, welche in Abhängigkeit einer Bestrahlung Ladungsträger freisetzen. Eine Anordnung kann in integrierter Form auf einem Halbleiterkörper hergestellt werden.

### Bezugszeichenliste

- 1: Eingang
- 2: Ausgang
- 10, 10A: Korrekturschaltung
- 11, 12: Anschlüsse Ladungsspeicher
- 20: Kopplungsschaltung
- 30: Integrator
- 31, 32: Eingang Integrator
- 33: Ausgang Integrator
- 34: Schalter
- 35: Differenzverstärker
- 40: Schalteinrichtung
- 101 bis 105: Schalter
- T1 bis T6: Transistor
- IS1, IS2: Stromquelle
- C1, C2: Ladungsspeicher
- VDD: Versorgungspotenzialanschluss
- VSS: Bezugspotenzialanschluss
- VCH: Ladepotenzialanschluss
- V_{REF}: Referenzpotenzialanschluss
- S101 bis S105: Steuersignal
- P1, P2, P3: Zeitabschnitt
- IR: Referenzanschluss
- IB: Stromanschluss

## Patentansprüche

1. Anordnung zur Ladungsintegration, umfassend
- einen Eingang (1) zur Zuführung eines ladungsabhängigen Signals;
- einen Integrator (30), der zur Integration eines eingangsseitig anliegenden Signals ausgeführt ist;
- eine Kopplungsschaltung (20) mit wenigstens zwei einnehmbaren Betriebszuständen zur Kopplung des Eingangs (1) mit dem Integrator (30), die Kopplungsschaltung (20) aufweisend ein temperaturabhängiges Kopplungsverhalten;
**gekennzeichnet durch**
- eine getaktet zu betreibende Korrekturschaltung (10), die zur Übertragung einer Ladungsmenge mit dem Eingang (1) gekoppelt ist und derart dimensioniert ist, dass diese ein Temperaturverhalten aufweist, das zur Kompensation des temperaturabhängigen Kopplungsverhaltens der Kopplungsschaltung (20) geeignet ist;
- wobei die Kopplungsschaltung (20) einen ersten und einen zweiten Transistor (T1, T2) umfasst, bei der der erste Transistor (T1) ausgebildet ist, in Abhängigkeit des ladungsabhängigen Signals gesteuert zu werden, und bei der der zweite Transistor (T2) ausgebildet ist, das ladungsabhängige Signal in Abhängigkeit einer Steuerung weiterzuleiten, die **durch** den ersten Transistor (T1) erfolgt;
- wobei die Korrekturschaltung (10) einen mit dem Eingang (1) schaltbar gekoppelten Ladungsspeicher (C1), der einen von einer vorbestimmten Ladespannung abhängigen Ladezustand annehmen kann, sowie einen dritten und einen vierten Transistor (T3, T4) aufweist, bei der der dritte Transistor (T3) ausgebildet ist, in Abhängigkeit des Ladezustands des Ladungsspeichers (C1) gesteuert zu werden, und der vierte Transistor (T4) ausgebildet ist, in Abhängigkeit einer Steuerung, die **durch** den dritten Transistor (T3) erfolgt, den Ladezustand des Ladungsspeichers (C1) zu beeinflussen, wobei der erste und der dritte Transistor (T1, T3) ein sich einander entsprechendes Temperaturverhalten aufweisen; und
- wobei in der Korrekturschaltung (10) und der Kopplungsschaltung (20) jeweils eine Stromquelle (IS1, IS2) vorgesehen ist, die ein einander entsprechendes Temperaturverhalten aufweisen.

2. Anordnung nach Anspruch 1,
bei der die Transistoren (T1, T2, T3, T4) als Feldeffekttransistoren ausgeführt sind.

3. Anordnung nach Anspruch 1 oder 2,
bei der der Integrator (30) einen Differenzverstärker (35) aufweist, der über einen weiteren Ladungsspeicher (C2) rückgekoppelt ist.

4. Anordnung nach einem der Ansprüche 1 bis 3,
bei der der Integrator (30) mit der Kopplungsschaltung (20) über eine Schalteinrichtung (40) gekoppelt ist, die in Abhängigkeit eines Steuersignals schaltbar ist.

5. Verfahren zur Ladungsintegration, umfassend die Schritte:
- Speichern einer vorbestimmten Ladungsmenge;
- Erzeugen eines ersten Steuersignals in Abhängigkeit der gespeicherten Ladungsmenge;
- Anpassen der gespeicherten Ladungsmenge in Abhängigkeit des ersten Steuersignals;
- Erzeugen eines ersten ladungsabhängigen Signals als Funktion der angepassten Ladungsmenge;
- Zusammenführen des ersten ladungsabhängigen Signals und eines zugeführten zweiten ladungsabhängigen Signals;
- Erzeugen eines zweiten Steuersignals in Abhängigkeit des zusammengeführten Signals;
- Weiterleiten des zusammengeführten Signals in Abhängigkeit des zweiten Steuersignals; und
- Integrieren des weitergeleiteten Signals zu einem Ausgangssignal;
- wobei das erste und das zweite Steuersignal temperaturabhängig erzeugt werden.

6. Verfahren nach Anspruch 5,
bei dem das Integrieren über einen Differenzverstärker (35) erfolgt, der über einen kapazitiven Ladungsspeicher (C2) rückgekoppelt ist.

7. Verwendung einer Anordnung nach einem der Ansprüche 1 bis 4 in einem digitalen Röntgengerät.

## Claims

1. An arrangement for charge integration, comprising
- an input (1) for supplying a charge-dependent signal;
- an integrator (30) designed for integrating a signal applied to the input side;
- a coupling circuit (20) with at least two possible operational states for coupling the input (1) to the integrator (30), the coupling circuit (20) having a temperature-dependent coupling behavior;
**characterized by**
- a correction circuit (10) to be operated in clocked mode, which is coupled to the input (1) for transferring a charge quantity and dimensioned such that it has a temperature behavior suitable for compensating the temperature-dependent coupling behavior of the coupling circuit (20);
- the coupling circuit (20) comprising first and second transistors (T1, T2), in which the first transistor (T1) is configured so as to be controlled depending on the charge-dependent signal, and the second transistor (T2) is configured so as to transmit the charge-dependent signal depending on a control process performed by the first transistor (T1);
- the correction circuit (10) comprising a charge storage means (C1) coupled to the input (1) in switchable manner and being able to assume a charge state which depends on a predetermined charging voltage, and third and fourth transistors (T3, T4), in which the third transistor (T3) is configured so as to be controlled depending on the charge state of the charge storage means (C1), and the fourth transistor (T4) is configured so as to take influence on the charge state of the charge storage means (C1) depending on a control process performed by the third transistor (T3), the first and third transistors (T1, T3) having a temperature behavior corresponding to each other; and
- the correction circuit (10) and the coupling circuit (20) being provided with one current source (IS1, IS2) each having a temperature behavior corresponding to each other.

2. The arrangement according to claim 1,
in which the transistors (T1,T2, T3, T4) are implemented as field effect transistors.

3. The arrangement according to claim 1 or 2,
in which the integrator (30) comprises a differential amplifier (35) coupled back via a further charge storage means (C2).

4. The arrangement according to any of the claims 1 to 3,
in which the integrator (30) is coupled to the coupling circuit (20) via a switching device (40) which may be switched depending on a control signal.

5. A method of charge integration, comprising the following steps:
- accumulating a predetermined charge quantity;
- generating a first control signal depending on the accumulated charge quantity;
- adapting the accumulated charge quantity depending on the first control signal;
- generating a first charge-dependent signal as a function of the adapted charge quantity;
- combining the first charge-dependent signal with a supplied second charge-dependent signal;
- generating a second control signal depending on the combined signal;
- transmitting the combined signal depending on the second control signal; and
- integrating the transmitted signal to form an output signal;
- wherein the first and second control signals are generated in a temperature-dependent manner.

6. The arrangement according to claim 5,
in which the integration is performed by a differential amplifier (35) which is coupled back via a capacitive charge storage means (C2).

7. The use of an arrangement according to any of the claims 1 to 4 in a digital X-ray equipment.

## Revendications

1. Dispositif d'intégration de charge, comportant
- une entrée (1) destinée à acheminer un signal dépendant de la charge ;
- un intégrateur (30) exécuté pour intégrer un signal présent à l'entrée ;
- un circuit de couplage (20) pouvant prendre au moins deux états de fonctionnement pour le couplage de l'entrée (1) à l'intégrateur (30), le circuit de couplage (20) présentant un comportement de couplage dépendant de la température ;
**caractérisé par**
- un circuit de correction (10) à utiliser en cadence, couplé à l'entrée (1) pour transférer une quantité de charge et dimensionné de façon à présenter un comportement de température apte à compenser le comportement de couplage dépendant de la température du circuit de couplage (20) ;
- le circuit de couplage (20) comportant un premier et un deuxième transistor (T1, T2), le premier transistor (T1) étant constitué pour être commandé en fonction du signal dépendant de la charge, et le deuxième transistor (T2) étant constitué pour transmettre le signal dépendant de la charge en fonction d'une commande réalisée par le premier transistor (T1) ;
- le circuit de correction (10) présentant un accumulateur de charge (C1) couplé à l'entrée (1) de manière commutable et pouvant prendre un état de charge dépendant d'une tension de charge prédéterminée, ainsi qu'un troisième et un quatrième transistor (T3, T4), le troisième transistor (T3) étant constitué pour être commandé en fonction de l'état de charge de l'accumulateur de charge (C1), et le quatrième transistor (T4) étant constitué pour influencer l'état de charge de l'accumulateur de charge (C1) en fonction d'une commande réalisée par le troisième transistor (T3), le premier et le troisième transistor (T1, T3) présentant un comportement de température se correspondant ; et
- une source de courant (IS1, IS2) étant prévue à la fois dans le circuit de correction (10) et le circuit de couplage (20), les sources de courant (IS1, IS2) présentant un comportement de température se correspondant.

2. Dispositif selon la revendication 1,
où les transistors (T1, T2, T3, T4) sont exécutés comme transistors à effet de champ.

3. Dispositif selon la revendication 1 ou 2,
où l'intégrateur (30) présente un amplificateur différentiel (35) qui est rétrocouplé via un accumulateur de charge supplémentaire (C2).

4. Dispositif selon l'une des revendications 1 à 3,
où l'intégrateur (30) est couplé au circuit de couplage (20) via un dispositif de commutation (40) qui est commutable en fonction d'un signal de commande.

5. Procédé d'intégration de charge, comportant les étapes suivantes :
- accumulation d'une quantité de charge prédéterminée ;
- production d'un premier signal de commande en fonction de la quantité de charge accumulée ;
- adaptation de la quantité de charge accumulée en fonction du premier signal de commande ;
- production d'un premier signal dépendant de la charge comme fonction de la quantité de charge adaptée ;
- regroupement du premier signal dépendant de la charge et d'un deuxième signal acheminé dépendant de la charge ;
- production d'un deuxième signal de commande en fonction du signal regroupé ;
- transmission du signal regroupé en fonction du deuxième signal de commande ; et
- intégration du signal transmis en un signal de sortie ;
- le premier et le deuxième signal de commande étant produits en fonction de la température.

6. Procédé selon la revendication 5,
où l'intégration est effectuée via un amplificateur différentiel (35) qui est rétrocouplé via un accumulateur de charge capacitif (C2).

7. Utilisation d'un dispositif selon l'une des revendications 1 à 4 dans un appareil de radiographie numérique.
